## Europäisches Patentamt

## European Patent Office

## Office européen des brevets

(19)

(11) Veröffentlichungsnummer: **0 202 279**
**B1**

(12)

# EUROPÄISCHE PATENTSCHRIFT

(45) Veröffentlichungstag der Patentschrift:
02.08.89

(51) Int. Cl.⁴: **H 01 L 21/56,** H 01 L 23/20

(21) Anmeldenummer: **85905776.2**

(22) Anmeldetag: **18.11.85**

(86) Internationale Anmeldenummer:
**PCT/DE 85/00475**

(87) Internationale Veröffentlichungsnummer:
**WO 86/03055 (22.05.86 Gazette 86/11)**

(54) **VERFAHREN ZUM EINKAPSELN VON MIKROELEKTRONISCHEN HALBLEITER- UND SCHICHTSCHALTUNGEN.**

(30) Priorität: **17.11.84 DE 3442131**

(43) Veröffentlichungstag der Anmeldung:
**26.11.86 Patentblatt 86/48**

(45) Bekanntmachung des Hinweises auf die Patenterteilung:
**02.08.89 Patentblatt 89/31**

(84) Benannte Vertragsstaaten:
**FR GB IT**

(56) Entgegenhaltungen:
**EP-A-0 122 687**
**DE-A-3 310 654**
**FR-A-2 404 992**
**US-A-4 388 132**

**Patents Abstracts of Japan, Vol.6, No.226, (E-141)(1104)11 November 1982 &JP,A, 57128948**
**Patents Abstracts of Japan, Vol. 6, No. 173 (E-129) (1051) 07 September 1982 &JP, A, 5790967**

(73) Patentinhaber: **Messerschmitt- Bölkow- Blohm Gesellschaft mit beschränkter Haftung, Robert- Koch- Strasse, D-8012 Ottobrunn (DE)**

(72) Erfinder: **MÖLLER, Werner, Ravensburger Strasse 77, D-7900 Ulm (DE)**
Erfinder: **GRAF VON LÜTTICHAU, Harald, Auf dem Berg 2, D-7312 Kirchheim (Teck) - Ötlingen (DE)**

## Beschreibung

**Verfahren zum Einkapseln von mikroelektronischen Halbleiterschaltungen und mikroelektronischen Halbleiterelementen**

Die Erfindung betrifft ein Verfahren zum Einkapseln von mikroelektronischen Hybrid-Halbleiterschaltungen oder von mikroelektronischen Halbleiterbauelementen.

Hochzuverlässige, mikroelektronische Schaltungen für professionelle, medizinische und militärische Anwendungen erfordern einen Langzeitigen Schutz gegen die Einwirkung von Feuchtigkeitsspuren oder korrosiven Stoffen. Zumeist verwendet man hierfür metallische oder keramische Gehäuse, die hermetisch dicht verschweißt oder verlötet sind. Derartige Gehäuse, z. B. Kovargehäuse, sowie die zugehörigen Verkapselungstechnologien, z. B. das Rollnaht-, Ringbuckel-, Elektronen- oder Laserstrahl-Schweißen oder die Glaslot- sowie die Anglasungstechniken sind sehr aufwendig bzw. kostspielig und für Mikroschaltungen thermisch nicht unkritisch.

Es wird daher seit Jahren versucht, die in der kommerziellen Elektronik, vor allem in der Konsumelektronik, bewährten, preiswerten sowie rationellen Kunststoffverpackungen für professionelle mikroelektronische Schaltungen hochzuzüchten.

Es wurden hierfür zahlreiche spezielle Kunststoffmassen und Vergußtechniken entwickelt, die z. B. in DE-PS-2 347 049, DE-AS-2 538 119, DE-AS-2 628 823, DE-AS-2 545 471, DE-OS-2 748 523, DE-OS-2 656 139, DE-OS-3 137 480 und DE-OS-3 151 902 beschrieben sind.

Es hat sich aber gezeigt, daß die vorgeschlagenen Lösungen nicht zu völlig gas- und wasserdichten Abdichtungen führen. Der höhere Ausdehnungskoeffizient der Kunststoff-Verkapselung führt nämlich bei größeren Temperaturschwankungen an den Substratgrenzflächen zu Spannungen und damit zu Ablösungen und Rissen. Bei hohen Zuverlässigkeitsanforderungen und starken thermomechanischen Schockbeanspruchungen (-65°/+250°C) werden daher Kunststoffkapselungen nicht verwendet. Auch nach MIL-M-38510 werden bisher nur hermetisch verschweißte oder verlötete Metall- und Keramikgehäuse akzeptiert.

Es ist ferner beispielsweise aus der DE-PS-2 347 049 bekannt, daß sich gebondete Halbleiterschaltungen durch elastische Abdeckschichten aus Kunststoffschaum schützen lassen. Bei starken Temperaturwechselbeanspruchungen muß aber insbesondere bei Schaumpolstern mit hohen thermomechanischen Spannungen in der Kapsel gerechnet werden, so daß sich die Grenzflächen trennen und Feuchtigkeit bzw. korrosive Stoffe entlang der Fugen eindringen können. Vermeidet man die Kapsel und vergießt die Abdeckschicht direkt mit einem im Ausdehnungskoeffizienten annähernd angepaßten Kunstharz (DE-OS-2 922 005), so ist die Wasserdampfundurchlässigkeit bzw. Riß- sowie Porenfreiheit nicht gewährleistet. Auch ist bei Epoxidharz-Silikonelastomer-Kombinationen (DE-OS-2 922 005) bei starken Temperaturwechselbeanspruchungen infolge der geringen Haftfestigkeit mit einem Ablösen zu rechnen, so daß sich bei Haarrissen die Feuchtigkeit über die gesamte Trennfuge verteilen kann.

Es ist nun ferner bekannt (DE-OS-2 551 778, DE-PS-1 514 478), Kondensatoren mit beidseitig kunststoff-kaschierten Metallfolien feuchtdicht zu verkapseln. Diese Technik setzt aber eine geometrisch einfache Bauelementenform und eine haftfest aufschrumpfende Kunststoff-Kaschierung voraus. Hybride, die mit gebondeten IC's oder kleinen diskreten Bauelementen dicht bestückt sind, lassen sich nicht drucklos fugen-, hohlraumfrei und haftfest kaschieren, so daß es bei Temperaturwechselbeanspruchungen zwischen -65° und +125°C zu Ablösungen oder Drahtverformungen kommt, die sich auch auf die elektrischen Funktionseigenschaften auswirken.

Weiterhin zählt zum Stand der Technik das aus der FR-A-2 404 992 bekannte Halbleiterbauelement, bei dem die auf einem Substrat-befindlichen Bauelement in eine weiche, siegelfähige Kunststoffschicht eingegossen und anschließend mit Kunstharz verkapselt sind.

Aus der EP-A-0 122 687 ist ferner eine laminierte Verkapselung bekannt, bei der eine Metallschicht auf eine Kunststoffschicht aufgetragen wird und eine weitere Kunststoffverstärkungsschicht ist auf der Metallschicht vorgesehen, während der Hohlraum zwischen Verkapselung und Bauelement mit einem hygroskopischen Material gefüllt wird. Aus der JP-A-57 128 948 ist ein eingekapseltes Halbleiterelement bekannt geworden, bei dem das Bauelement in eine Silikonschicht eingegossen und anschließend mit einer Kunststoff-Folie abgedeckt wird.

Alle bekannten Verfahren sind nicht dazu geeignet, die notwendige Sicherung der Verkapselung gegen Umwelteinflüsse insbesondere auch gegen mechanische Schocks und hohe Temperatur-Wechselbeanspruchungen zwischen -65°C und 125°C zu gewährleisten.

Es ist die Aufgabe der Erfindung, ein Verfahren zu schaffen, das die Vorteile der Kunststoffverpackung, u.a. die einfache, rationelle Formgebung, gute elektrische Isolation und geringe Material kosten, mit den Vorteilen der Metall- und Keramikgehäuse, nämlich thermomechanische Schockfestigkeit und Dichtigkeit, weitgehend verbindet und diese Eigenschaften noch verbessert.

Gemäß der Erfindung wird diese Aufgabe durch die Verfahrensschritte gemäß dem Kennzeichnungsteil der Ansprüche 1 bzw. 2 gelöst.

Die Unterfütterung der Kunststoff-Metall-Folie mit einer siegelfähigen Abdeckung, die sich fest mit der übergossenen Schaltung verbindet, löst die bisher aufgetretenen Probleme.

Einzelheiten der Erfindung ergeben sich aus den Unteransprüchen und der Beschreibung, in der anhand der Zeichnung mehrere Ausführungsbeispiele erläutert werden. Es zeigen:

Fig. 1 den Aufbau einer nach dem erfindungsgemäßen Verfahren eingekapselten Schaltung,
Fig. 2 schematisch die Schritte einer ersten und
Fig. 3 einer zweiten Variante des Verfahrens.

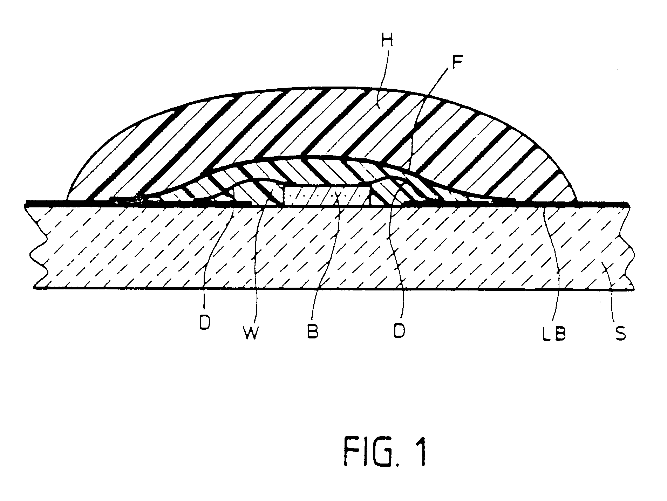

Fig. 1 zeigt den grundsätzlichen Aufbau einer
nach dem erfindungsgemäßen Verfahren eingekapselten Schaltung. Auf einem Substrat S, das
zweckmäßig aus $Al_2O_3$ besteht, haftet ein beispielsweise mit $Si_3N_4$ passivierter mikroelektronischer Baustein B, der in bekannter Weise mit
Bonddrähten D, die aus Gold, Aluminium oder
anderem hochleitfähigem Metall bestehen, mit
den Leiterbahnen LB elektrisch verbunden ist.
Der Baustein B und die Bonddrähte befinden sich
innerhalb einer weichen Kunststoffschicht W.
Diese ist mit einer Folie F abgedeckt, die eine
Metallschicht enthält und deren Aufbau weiter
unten beschrieben wird. Schließlich ist das
Ganze mit Epoxidharz H mit hochreiner $SiO_2$-
oder Kreidefüllung eingekapselt.

In den letzten Jahren wurden von der Fa.
Wacker Elastomere aus Silikon und (ca. 50 %)
thermoplastischen Polymeren entwickelt und zur
Verfügung gestellt, die sich gegenüber den
reinen Silikonelastomeren durch erhöhte mechanische Festigkeit, befriedigende Haftung auf
Bauteilen, Keramik, Metall usw. sowie vor allem
durch geringe Wasserdampfdurchlässigkeit auszeichnen und damit als Deckschicht hervorragend geeignet sind. Zudem wurde im Rahmen
der der Erfindung zugrundeliegenden Untersuchungen gefunden, daß sich die verwendeten
Elastomere durch Thermokompression mit der
Kunststoff-Folie verschweißen lassen.

Hieraus ergibt sich ein Verbundsystem aus
Kunststoff-Metallschichten. Die unterschiedlichen Ausdehnungskoeffizienten, die elektrische
Kontaktierung und weitere Schwierigkeiten stellen sich einer solchen Lösung, z. B. einer kombinierten Verguß- und Aufdampftechnik, zunächst entgegen. Die metallischen Aufdampfschichten sind nicht gasdicht und können durch
Kunstharze, z. B. Epoxidharze, bei Wärme- und
Feuchtigkeitseinwirkung angegriffen werden.

Eine vollständige Lösung nach der Erfindung
besteht also darin, daß die z. B. mit $Si_3N_4$
passivierte, auf ein Substrat S gebondete mikroelektronische Schaltung B mit einer im Betriebstemperaturbereich weichen Kunststoffschicht W überzogen wird, die sich mit einer
warm- und rißfrei verformbaren Kunststoff-Metall-
Kunststoff-Verbundfolie F versiegeln oder verkleben läßt und ggf. mit einem hochgefüllten,
stark vernetzten Kunstharz H verkapselt und
verfestigt wird.

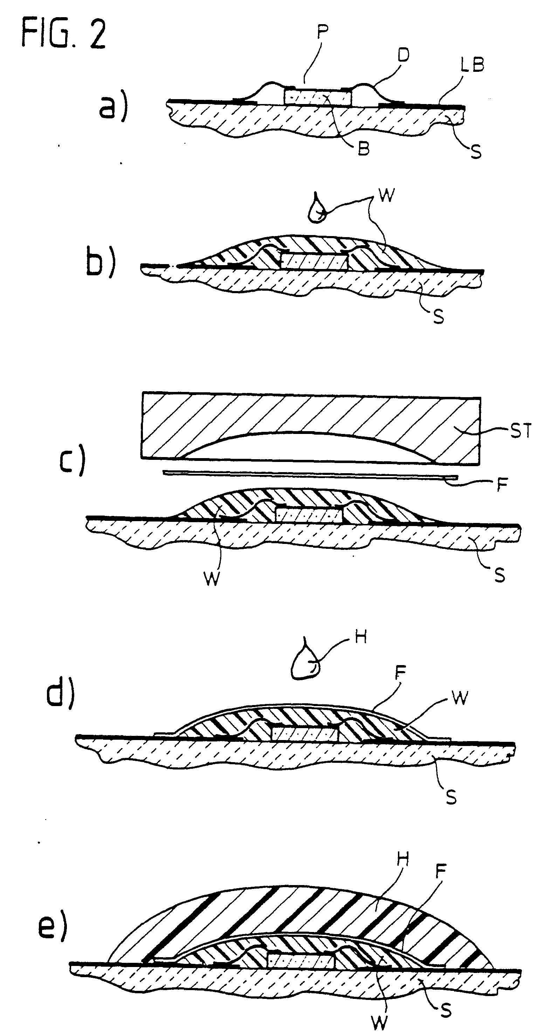

Zur rationellen Durchführung des erfindungsgemäßen Verfahrens eignet sich besonders gut
das bewährte Heißsiegelverfahren nach Fig. 2.

Dabei befindet sich gemäß Schritt a) zunächst
der gebondete Baustein B auf dem Substrat S.
Die Bond-Drähte D verbinden den Baustein B
elektrisch mit den Leiterbahnen LB. Eine Passivierung P verhindert unerwünschte Korrosion. In diesem Zustand wird die vorbereitete Schaltung
zunächst vorgewärmt.

Sodann wird gemäß Schritt b) ein niederviskoses, flüssiges Elastomer W aufgebracht. Die
hieraus hervorgehende Schicht W ist heißsiegelfähig. Beim dritten Schritt c) wird die
Metall-Verbundfolie F aufgelegt und mit einem
auf etwa 200° C erhitzten Hohlstempel ST auf die
weiche Schicht W aufgepreßt. Dabei verbindet
sich die der Schicht W zugewandte Kunststoffseite der Folie F mit derselben unter dem Einfluß
von Wärme und Druck. Beim nachfolgenden
Abkühlen verfestigt sich die Füllung u. Daneben
hat sich eine Verformung der Verbundfolie beim
Ausstanzen als vorteilhaft erwiesen.

Sodann wird ggf. gemäß Verfahrensschritt d)
das bisher erzeugte Element mit einem Epoxidharz H vergossen. Das in Fig. 2e dargestellte
Endprodukt entspricht dem nach Fig. 1.

Dieses Verfahren beruht also darauf, daß z. B.
mit Polyolefinen modifizierte Silikone mit Polypropylenfolien bei 160 - 190° C unter Druck leicht
verformt und versiegelt werden können. Als
innere Metallschicht kommen vorzugsweise gewalzte Kupfer- oder Aluminium-Folien, als Abdeckung hochreine Polypropylen-Polyäthylen-,
Polyäthylentereplethalat-, Polycarbonat-, Polyimid-Folien in Frage. Eine Delaminierung oder
Rißbildung ist bei derartigen Verbundfolien unbekannt, die Gas- und Feuchtigkeitsdurchlässigkeit um viele Zehnerpotenzen kleiner als bei
Epoxidharz- oder Silikonelastomer-Verpackungen. Eine Diffusion und Permeation ist nur
entlang der ca. 10 - 100 μ dicken, aber millimeterlangen Grenzschicht zwischen Halbleiterschaltung und Aluminiumschicht möglich.

Die beidseitig elektrisch isolierte, gewalzte
Metallfolie erleichtert bei Leistungshalbleiterschaltungen oder Leistungshybridschaltungen
zudem einen schnellen Temperaturausgleich.

Vorteilhaft werden zum Aufbringen der Folien
an sich bekannte automatische Die-Bonder verwendet. Diese sind zweckmäßig mit dem Stanzwerkzeug für die Folien im gleichen Arbeitstakt
gekoppelt.

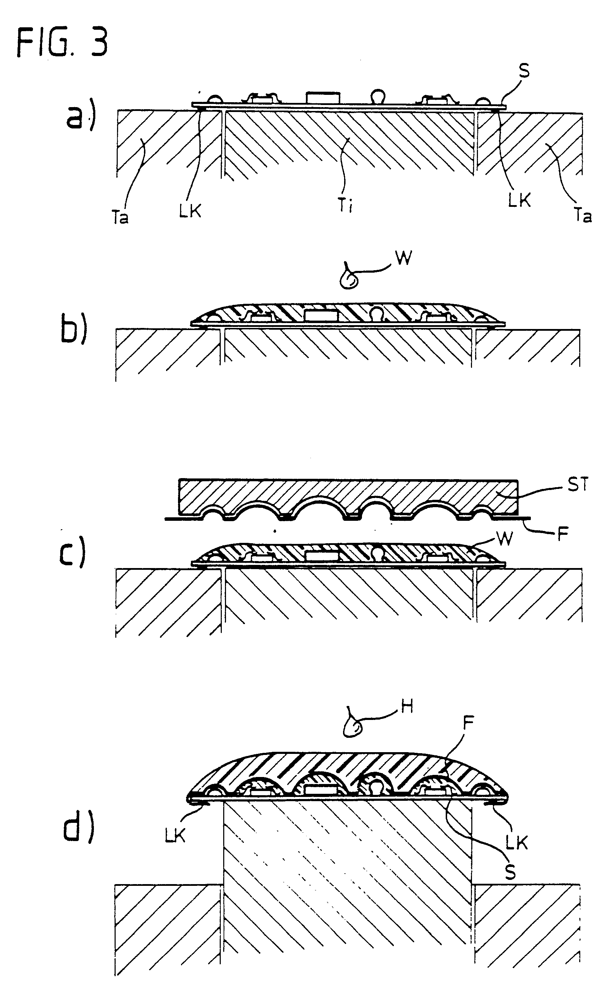

Fig. 3 zeigt eine andere Variante des erfindungsgemäßen Verfahrens. Hierbei befindet sich
auf einem aus Innenteil Ti und Außenteil Ta
bestehenden Träger das Substrat S mit den
Bauelementen. Der Rand des Substrats ragt über
den Innenteil Ti des Trägers hinaus und ist
rückseitig mit einem Lotkranz LK bedruckt. Die
Leiterbahnen sind beim Dickschicht-Siebdruck
mit einer Dielektrikumsschicht gegen den Lotkranz isoliert. Der Verfahrensschritt b) erfolgt wie
im Beispiel nach Fig. 2.

Im Verfahrensschritt c), also beim Aufbringen
der Folie, wird hier eine entsprechend der
Topologie der Bauelemente vorgeformte Folie F
verwendet. Ebenso ist der Stempel ST der
Formgebung der Folie angepaßt. Nach Aufbringen der Folie wird diese an den Rändern des
Substrates nach Entfernen des Außenteiles TA
des Trägers umgefalzt und entsprechend Fig. 3d
mit dem Lotkranz verlötet. Anschließend kann das Element mit Epoxidharz H vergossen werden.

Besonders geeignet zum Verlöten sind einseitig kaschierte Kupferfolien. Der Epoxidharz-Quarz-Verguß dient als mechanischer Schutz.

Im folgenden werden drei Ausführungsbeispiele angegeben.

**Beispiel 1:**

Der Chip bzw. die passivierte Halbleiterschaltung wird auf den Carrier gelegt und an den Anschlüssen gebondet. Der Chip sowie alle Bondanschlüsse werden mit einem niederviskosen Kunststoff überzogen, der durch eine sehr geringe Gas- und Wasserdampfdurchlässigkeit, hohe Flexibilität und Siegelfähigkeit gekennzeichnet ist. In diesem Fall wird eine polyolefinmodifizierte Silikon-Lösung in Benzin auf das mit p-Methyldisiloxan-Methylmethacrylat grundierte Substrat gebracht.

Aus einer Polypropylen-(75 μ)-, Aluminium-(10 μ)-, Polyäthylenterephtalat-(15 μ)-Verbundfolie wird heiß (ca. 120°) eine für den Chip dimensionierte Kappe ausgestanzt, mit einem Die-Bonder über den Chip-Carrier gestülpt und mittels eines heißen Hohlstempels mit dem Weichverguß dicht versiegelt. Der ca. 180°C heiße Hohlstempel preßt die Folie mit dem flüssigen Weichverguß so auf das Substrat, daß die Siegelschicht unter ca. 20 μ liegt. Anschließend wird mit hochreinen, flexiblen Epoxidharz-/Quarzmehl-Vergußmassen die Kappe bzw. verkapselte Schaltung vergossen. Als Vergußmasse eignet sich ein Harz aus

| | | |
|---|---|---|
| 100 | Gew. T. | ECN 1280 (CIBA), |
| 120 | Gew. T. | Dodeceylbernsteinsäureanhydrid, |
| 0,5 | Gew. T. | Piperidin, |
| 2 | Gew. T. | p-Methyldisiloxan-Methylmethacrylat, |
| 300 | Gew. T. | vakuumgetrocknetes, hochreines Quarzmehl (X = 30 μ). |

Die thixotrope Vergußmasse wird bei 140° gemischt aufgebracht und fünf Stunden gehärtet.

**Beispiel 2:**

Eine Dickschicht-Hybridschaltung mit Halbleiterchips und diskreten Bauelementen wird mit einer heißen Polyethylen/Xylol-Lösung lackiert, mit einer entsprechend zugeschnittenen evtl. vorgeformten Verbundfolie abgedeckt, an das Substrat gepreßt, verklebt bzw. versiegelt. Die verkapselte Hybridschaltung wird anschließend mit einem gefüllten Epoxidharz umpreßt bzw. vergossen.

**Beispiel 3:**

Eine gebondete Hybridschaltung wird auf ca. 100°C vorgewärmt, auf eine Vakuum-Haltevorrichtung gebracht und mit einer Kupfer-(25 μ)-Klebefolie, die entsprechend der Schaltung vorgestanzt und vorgeformt ist, abgedeckt.

Die Leiterbahnen der Schaltung werden beim Siebdruck an den vorgesehenen Kontakt- bzw. Lötstellen mit Dielektrikumspaste überschichtet. Vor der Folienversiegelung werden diese Stellen mit Lötpaste bedruckt.

Unter Vakuum wird die Folie gefalzt, mit dem Harz versiegelt, anschließend verlötet und mit einem gefüllten Epoxidharz umpreßt oder vergossen.

**Patentansprüche**

1. Verfahren zum Einkapseln von auf einem Substrat angeordneten mikroelektronischen Hybrid-Halbleiterschaltungen oder von mikroelektronischen Halbleiterelementen mit mehreren Schichten, dadurch gekennzeichnet, daß

- die auf dem Substrat (S) befindlichen Halbleiterschaltungen oder Halbleiterelemente (B) mit einer weichen, siegelfähigen Kunststoffschicht (W) übergossen und

- mit einer aus drei Schichten bestehenden Verbundfolie (F) abgedeckt werden,

- deren erste, der siegelfähigen Kunststoffschicht zugewandte Schicht aus einem siegelfähigen Polyolefin, vorzugsweise Polypropylen mit einer Schichtdicke von 10 - 100 μm, vorzugsweise von 75 μm,

- deren zweite Schicht aus einem verformbaren Metall, vorzugsweise Aluminium mit einer Schichtdicke von 0,25 - 250 μm, vorzugsweise von 10 - 30 μm,

- und deren dritte Schicht aus einem klebefähigen Polyester, vorzugsweise Polyäthylenterephthalat mit einer Schichtdicke von 1 - 100 μm, vorzugsweise 10 μm besteht,

- und abschließend die mit der Verbundfolie abgedeckten Halbleiterschaltungen oder Halbleiterelemente mit Kunstharz (H) verkapselt werden, und

- die erste Schicht der Folie mit der siegelfähigen Kunststoffschicht (W) und

- die dritte Schicht mit dem Kunstharz (H) verbunden wird.

2. Verfahren zum Einkapseln von auf einem Substrat angeordneten mikroelektronischen Hybrid-Halbleiterschaltungen oder mikroelektronischen Halbleiterelementen mit mehreren Schichten, dadurch gekennzeichnet, daß

- die auf dem Substrat (S) befindlichen Halbleiterschaltungen oder Halbleiterelemente (B) mit einer weichen, siegelfähigen Kunststoffschicht (H) übergossen und

- mit einer aus zwei Schichten bestehende Verbundfolie (F) abgedeckt werden,

- deren erste, der siegelfähigen Kunststoffschicht zugewandte Schicht aus einem siegelfähigen Polyolefin, vorzugsweise Polypropylen mit einer Schichtdicke von 10 - 100 µm, vorzugsweise von 75 µm, und

- deren zweite Schicht aus einem verform- und verlötbaren Metall, vorzugsweise Kupfer mit einer Schichtdicke von 0,25 - 250 µm, vorzugsweise von 10 - 30 µm besteht,

- die Folie mit der Kunststoffseite nach innen gefalzt und mit einem vorher auf das Substrat (S) gedruckten Lotkranz (LK) hermetisch dicht verlötet wird

- und abschließend die mit der Verbundfolie abgedeckten Halbleiterschaltungen oder Halbleiterelemente mit Kunstharz (H) verkapselt werden

- und die erste Schicht der Folie mit der siegelfähigen Kunststoffschicht (W) verbunden wird.

3. Verfahren nach Anspruch 1 oder 2, dadurch gekennzeichnet, daß zum Übergießen hochreine, gegenüber den Schaltungselementen inerte, niederviskose, flexible Epoxidharze mit guten Hafteigenschaften gegenüber Halbleiterschaltungen und Verbundfolien verwendet werden.

4. Verfahren nach Anspruch 1 oder 2, dadurch gekennzeichnet, daß zum Übergießen ein hochreiner, weicher, gegenüber der Halbleiterschaltung inerter, heißsiegelfähiger Überzug, insbesondere aus polyolefinhaltigen, modifizierten Silikonen oder aus Silikonkleber auf Silikon-Fluor-Basis verwendet wird.

5. Verfahren nach einem der vorhergehenden Ansprüche 1 bis 4, dadurch gekennzeichnet, daß das Verbundsystem aus der Kunststoffschicht (W) und Verbundfolie durch eine Heißsiegelverformung bei Temperaturen von 30 - 250°, vorzugsweise 160 - 190°, bei Drücken von 1 - 50 bar, vorzugsweise 5 - 10 bar außerhalb einer für elektrische Anschlüsse vorgesehenen Verdrahtung bzw. der Bondstellen hergestellt wird.

6. Verfahren nach einem der vorhergehenden Ansprüche 1 bis 5, dadurch gekennzeichnet, daß zur Erhitzung und Verformung heizbare Hohlstempel (ST) oder Matrizen verwendet werden.

7. Verfahren nach einem der vorhergehenden Ansprüche 1 bis 6, dadurch gekennzeichnet, daß die Verbundfolienverkapselung vergossen wird.

8. Mikroelektronische Hybrid-Halbleiterschaltung, dadurch gekennzeichnet, daß die auf einem Substrat (S) befindliche Bauelemente (B) in eine weiche, siegelfähige Kunststoffschicht (W) eingegossen, mit einer Kunststoff-Metall-Verbundfolie (F) abgedeckt und anschließend mit Kunstharz (H) verkapselt wird, wobei die Folie (F) aus drei Schichten besteht, deren erste Schicht aus einem siegelfähigen Polyolefin, vorzugsweise Polypropylen mit einer Schichtdicke von 10 - 100 µm, vorzugsweise von 75 µm, deren zweite Schicht aus einem verformbaren Metall, vorzugsweise Aluminium mit einer Schichtdicke von 0,25 - 250 µm, vorzugsweise von 10 - 30 µm, und deren dritte Schicht aus einem klebefähigen Polyester, vorzugsweise Polyäthylenterephthalat mit einer Schichtdicke von 1 - 100 µm, vorzugsweise 10 µm besteht, und die erste Schicht der Folie mit der siegelfähigen Füllung (W) und die dritte Schicht mit dem Kunstharz (H) verbunden ist.

9. Mikroelektronische Hybrid-Halbleiterschaltung, dadurch gekennzeichnet, daß die auf einem Substrat (S) befindliche Bauelement (B) in eine weiche, siegelfähige Kunststoffschicht (W) eingegossen, mit einer Kunststoff-Metall-Verbundfolie (F) abdgedeckt und auschließend mit Kunstharz (H) verkapselt wird, wobei die Folie (F) aus zwei Schichten besteht, deren erste Schicht aus einem siegelfähigen Polyolefin, vorzugsweise Polypropylen mit einer Schichtdicke von 10 - 100 µm, vorzugsweise von 75 µm, und deren zweite Schicht aus einem verform- und verlötbaren Metall, vorzugsweise Kupfer mit einer Schichticke von 0,25 - 250 µm, vorzugsweise von 10 - 30 µm besteht, und wobei die Folie mit der Kunststoffseite nach innen gefalzt und mit einem vorher auf das Substrat (S) gedruckten Lotkranz (LK) hermetisch dicht verlötet ist.

**Claims**

1. A process for encapsulating micro-electronic hybrid semi-conductor circuits arranged on a substrate or multi-layered micro-electronic semi-conductor components, characterised in that

- the semi-conductor circuits or semi-conductor components (B) located on the substrate (S) receive a soft, sealable poured-on plastic coating (W) and

- are covered with a composite foil (F) consisting of three layers,

- the first of which, facing the sealable plastic layer, consists of a sealable polyolefine, preferably polypropylene with a layer thickness of 10 - 100 µm, preferably 75 µm,

- the second of which consists of a malleable metal, preferably aluminium, with a layer thickness of 0.25 - 250 µm, preferably 10 - 30 µn,

- and the third of which consists of an adhesive polyester, preferably polyethylene-terephthalate with a layer thickness between 1 - 100 µm, preferably 10 µm and finally the semiconductor circuits or semiconductor components covered by the composite foil are encapsulated with a synthetic resin (H), and

- the first layer of the foil is bonded to the sealable plastic layer (W), and

- the third layer is bonded to the synthetic resin (H).

2. A process for encapsulating micro-electronic hybrid semiconductor circuits arranged on a substrate or multi-layered micro-electronic semi-conductor components, characterised in that

- the semiconductor circuits or the semiconductor components (B) located on the substrate (S) receive a soft, sealable poured-on plastic coating (W), and

- are covered with a composite foil (F) consisting of two layers,

- the first of which, facing the sealable plastic layer, consists of a sealable polyolefin, preferably polypropylene, with a layer thickness of 10 - 100 μm, preferably 75 μm, and

- the second of which consists of a malleable or solderable metal, preferably copper, with a layer thickness of 0.25 - 250 μm, preferably 10 - 30 μm,

- the foil is folded with the plastic-covered side inward and is soldered hermetically tight with a solder ring (LK) previously printed on the substrate,

- and finally the semiconductor circuits or semiconductor components covered by the composite foil are encapsulated in synthetic resin (H),

- and the first layer of the foil is bonded to the sealable plastic layer (W).

3. A process according to Claim 1 or 2, characterised in that for the pouring-on there are employed highly pure, low-viscosity, flexible epoxy resins which are inert with respect to the circuit components and which have good adhesiveness relative to the semiconductor circuits and the composite foils.

4. A process according to Claim 1 or 2, characterised in that for the pouring-on there is employed a highly pure, soft, hot-sealable coating which is inert with respect to the semiconductor circuit, consisting especially of polyolefine-containing, modified silicons or silicon adhesives on silicon-fluorine base.

5. A process according to any one of the preceding Claims 1 to 4, characterised in that the composite system is formed of the plastic layer (W) and the composite foil by a hot-seal molding at temperatures of 30 - 250°C, preferably 160 to 190°C, at pressures of 1 - 50 bar, preferably 5 - 10 bar, outside a zone provided for wiring electrical connections or for the bonding locations.

6. A process according to any one of the preceding Claims 1 to 5, characterised in that for heating and molding heatable hollow dies (ST) or matrices are utilized.

7. A process according to any one of the preceding Claims 1 to 6, characterised in that the encapsulation of the composite foil is effected by pouring.

8. A microelectronic hybrid semiconductor circuit, characterised in that the components (B) located on a substrate (S) are embedded into a soft, sealable plastic layer (W) are covered with a plastic-metal composite foil (F) and are thereafter encapsulated in a synthetic resin (H), in which the foil (F) is composed of three layers, the first of which consists of a sealable polyolefine, preferably polypropylene with a layer thickness of 10 - 100 μm, preferably 75 μm, the second layer of which consists of a malleable metal, preferably aluminium, with a layer thickness of 0.25 to 250 μm, preferably of 10 - 30 μm, and the third layer of which consists of an adhesive polyester, preferably polyethylene-terephthalate with a layer thickness of 1 - 100 μm, preferably 10 μm, and in which the first layer of the foil is bonded to the sealable filling (W) while the third layer is bonded to the synthetic resin (H).

9. A microelectronic hybrid-semiconductor circuit, characterised in that the components (B) located on a substrate (S) are embedded in a soft, sealable plastic layer (W) are covered with a composite plastic-metal foil (F) and are thereafter encapsulated in a synthetic resin (H) in which the foil (F) is composed of two layers, the first of which consists of a sealable polyolefin, preferably polypropylene with a layer thickness of 10 - 100 μm preferably 75 μm, and the second layer of which consists of a malleable and solderable metal, preferably copper, with a layer thickness of 0.25 - 250 μm preferably 10 - 30 μm and in which the foil is folded with its plastic side inwards and is then hermetically soldered to a solder ring (LK) previously printed on the substrate (S).

**Revendications**

1. Procédé d'encapsulage de circuits semi-conducteurs hybrides microélectroniques ou de composants semiconducteurs microélectroniques à plusieurs couches, disposés sur un substrat, caractérisé en ce que

- les circuits semi-conducteurs ou les composants semi-conducteurs (B) se trouvant sur le substrat (S) sont enrobés par coulée d'une couche souple de matière plastique (W) scellable et

- sont recouverts d'une feuille composite (F) formée de trois couches,

- dont la première couche tournée vers la couche de matière plastique scellable est constituée d'une polyoléfine scellable, de préférence de polypropylène ayant une épaisseur de couche qui est comprise entre 10 et 100 μm et est de préférence de 75 μm,

- dont la deuxième couche est constituée d'un métal déformable, de préférence d'aluminium ayant une épaisseur de couche comprise entre 0,25 μm et 250 μm, de préférence entre 10 et 30 μm,

- dont la troisième couche est constituée d'un polyester collable, de préférence de poly(téréphtalate d'éthylène) ayant une épaisseur de couche qui est comprise entre 1 et 100 μm et est de préférence de 10 μm,

- et pour finir les composants semi-conducteurs ou les circuits semi-conducteurs recouverts de la feuille composite sont encapsulés avec de la résine synthétique (H), et

- la première couche de la feuille est reliée à la couche de matière plastique (W) scellable et

- la troisième couche est reliée à la résine synthétique (H).

2 Procédé d'encapsulage de circuits semi-conducteurs hybrides microélectroniques ou de composants semiconducteurs microélectroniques à plusieurs couches, disposés sur un substrat, caractérisé en ce que

- les circuits semi-conducteurs ou les composants semi-conducteurs (B) se trouvant sur le substrat (S) sont enrobés par coulée d'une couche souple de matière plastique (W) scellable et

- sont recouverts d'une feuille composite (F) formée de deux couches,

- dont la première couche tournée vers la couche de matière plastique scellable est constituée d'une polyoléfine scellable, de préférence de polypropylène ayant une épaisseur de couche qui est comprise entre 10 et 100 µm et est de préférence de 75 µm, et

- dont la deuxième couche est constituée d'un métal pouvant être déformé et brasé, de préférence de cuivre ayant une épaisseur de couche comprise entre 0,25 et 250 µm, de préférence entre 10 et 30 µm,

- la feuille est pliée à son bord avec le côté matière plastique tourné vers l'intérieur et est brasée hermétiquement à une couronne de brasure (LK) préalablement imprimée sur le substrat (S),

- et pour finir les composants semi-conducteurs ou les circuits semi-conducteurs recouverts de la feuille composite sont encapsulés à l'aide de résine synthétique (H),

- et la première couche de la feuille est reliée à la couche de matière plastique (W) scellable.

3. Procédé selon la revendication 1 ou 2, caractérisé en ce que pour l'enrobage, on utilise des résines époxy flexibles, de faible viscosité, de grande pureté, inertes par rapport aux composants des circuits et ayant de bonnes propriétés d'adhérence par rapport aux circuits semi-conducteurs et aux feuilles composites.

4. Procédé selon la revendication 1 ou 2, caractérisé en ce que pour l'enrobage, on utilise un revêtement thermoscellable, de grande pureté, souple et inerte par rapport au circuit semi-conducteur, en particulier composé de silicones modifiées contenant des polyoléfines ou de colle silicone à base de silicone et de fluor.

5. Procédé selon l'une des revendications 1 à 4, caractérisé en ce que le système composite constitué de la couche de matière plastique (W) et de la feuille composite est fabriqué par déformation avec thermoscellement à des températures comprises entre 30 et 250°, de préférence entre 160 et 190°, et des pressions comprises entre 1 et 50 bars, de préférence entre 5 et 10 bars, à l'extérieur d'un câblage prévu pour des raccordements électriques et des points de bonding.

6. Procédé selon l'une des revendications 1 à 5, caractérisé en ce que des matrices ou des poinçons creux (ST) pouvant être chauffés sont utilisés pour le chauffage et la déformation.

7. Procédé selon l'une des revendications 1 à 6, caractérisé en ce que l'encapsulation par la feuille composite est enrobée.

8. Circuit semi-conducteur hybride microélectronique, caractérisé en ce que les composants (B) se trouvant sur un substrat (S) sont enrobés dans une couche souple de matière plastique (W) scellable, sont recouverts d'une feuille composite (F) en métal et matière plastique et sont ensuite encapsulés avec de la résine synthétique (H), la feuille (F) étant composée de trois couches, dont la première couche est constituée d'une polyoléfine scellable, de préférence de polypropylène ayant une épaisseur de couche qui est comprise entre 10 et 100 µm et est de préférence de 75 µm, dont la deuxième couche est constituée d'un métal déformable, de préférence d'aluminium ayant une épaisseur de couche comprise entre 0,25 et 250 µm, de préférence entre 10 et 30 µm, et dont la troisième couche est constituée d'un polyester collable, de préférence de poly(téréphtalate d'éthylène) ayant une épaisseur de couche qui est comprise entre 1 et 100 µm et est de préférence de 10 µm, et la première couche de la feuille étant reliée à la masse d'enrobage (W) scellable et la troisième couche à la résine synthétique.

9. Circuit semi-conducteur hybride microélectronique, caractérisé en ce que les composants (B) se trouvant sur un substrat (S) sont enrobés dans une couche souple de matière plastique (W) scellable sont recouverts d'une feuille composite (F) en métal et en matière plastique et sont ensuite encapsulés avec de la résine synthétique (H), la feuille (F) étant composée de deux couches, dont la première couche est constituée d'une polyoléfine scellable, de préférence de polypropylène ayant une épaisseur de couche qui est comprise entre 1 et 100 µm et est de préférence de 75 µm et dont la deuxième couche est constituée d'un métal pouvant être déformé et brasé, de préférence de cuivre ayant une épaisseur de couche comprise entre 0,25 et 250 µm, de préférence entre 10 et 30 µm, et la feuille étant pliée à son bord avec le côté matière plastique tourné vers l'intérieur et brasée hermétiquement à une couronne de brasure (LK) imprimée préalablement sur le substrat (S).

FIG. 1

FIG. 2

EP 0 202 279 B1

a)

b)

c)

d)

e)

3

FIG. 3